(19) **Europäisches Patentamt**

**European Patent Office**

**Office européen des brevets**

(11) **EP 1 378 556 A2**

(12) **EUROPÄISCHE PATENTANMELDUNG**

(43) Veröffentlichungstag:
    **07.01.2004 Patentblatt 2004/02**

(51) Int Cl.7: **C09K 11/80**, C09K 11/78,
    **H05B 33/14**, **H01L 33/00**

(21) Anmeldenummer: **03021392.0**

(22) Anmeldetag: **08.07.2000**

(84) Benannte Vertragsstaaten:
    **AT BE CH CY DE DK ES FI FR GB GR IE IT LI LU MC NL PT SE**

(30) Priorität: **23.07.1999 DE 19934126**
    **27.10.1999 DE 19951790**
    **30.12.1999 DE 19963791**

(62) Dokumentnummer(n) der früheren Anmeldung(en) nach Art. 76 EPÜ:
    **00956080.6 / 1 116 418**

(72) Erfinder:
    • **Debray, Alexandra**
      **90491 Nürnberg (DE)**
    • **Ellens, Andries, Dr.**
      **6716 CC Ede (NL)**
    • **Kummer, Franz. Dr.**
      **80797 München (DE)**
    • **Waitl, Günter**
      **93049 Nürnberg (DE)**
    • **Zwaschka, Franz, Dr.**
      **85737 Ismaning (DE)**

(71) Anmelder:
    • **Patent-Treuhand-Gesellschaft für elektrische Glühlampen mbH**
      **81536 München (DE)**
    • **Osram Opto Semiconductors GmbH**
      **93049 Regensburg (DE)**

Bemerkungen:
    Diese Anmeldung ist am 22 - 09 - 2003 als Teilanmeldung zu der unter INID-Kode 62 erwähnten Anmeldung eingereicht worden.

(54) **Leuchtstoff insbesondere für Lichtquellen und zugehörige Lichtquelle**

(57)    Ein Leuchtstoff für Lichtquellen, deren Emission im kurzwelligen optischen Spektralbereich liegt, hat eine Granatstruktur $A_3B_5O_{12}$. Er ist mit Ce aktiviert, wobei die zweite Komponente B mindestens eines der Elemente Al und Ga repräsentiert, und wobei die erste Komponente A Terbium enthält.

Insbesondere wird ein Granat der Struktur $(Tb_{1-x-y}SE_xCe_y)_3(Al,Ga)_5O_{12}$ verwendet, wobei
SE = Y, Gd, La und/oder Lu;
$0 \leq x \leq 0,5-y$;
$0 < y < 0,1$ gilt.

Emissionsspektrum des Leuchtstoffs nach Ausführungsbeispiel 1 bei Anregung mit 430 nm

FIG. 1

## Beschreibung

### Technisches Gebiet

Die Erfindung geht aus von einem Leuchtstoff, insbesondere für Lichtquellen und zugehörige Lichtquelle, gemäß dem Oberbegriff des Anspruchs 1. Es handelt sich dabei insbesondere um einen gelb emittierenden Granat-Leuchtstoff für die Anregung durch eine Lichtquelle mit kurzen Wellenlängen im sichtbaren blauen Spektralbereich, wodurch weißes Licht erzeugt wird. Als Lichtquelle eignet sich insbesondere eine Lampe (vor allem Leuchtstofflampe) oder eine LED (light emitting diode).

### Stand der Technik

Aus der WO 98/05078 ist bereits ein Leuchtstoff, insbesondere für Lichtquellen und zugehörige Lichtquelle bekannt. Als Leuchtstoff wird dort ein Granat der Struktur $A_3B_5O_{12}$ eingesetzt, dessen Wirtsgitter als erste Komponente A aus mindestens einer der Seltenen Erdmetalle Y, Lu, Sc, La, Gd oder Sm besteht. Weiter wird für die zweite Komponente B eines der Elemente Al, Ga oder In verwendet. Als Dotierstoff wird ausschließlich Ce eingesetzt.

Aus der WO 97/50132 ist ein sehr ähnlicher Leuchtstoff bekannt. Als Dotierstoff wird dort entweder Ce oder Tb eingesetzt. Während Ce im gelben Spektralbereich emittiert, liegt die Emission des Tb im grünen Spektralbereich. In beiden Fällen wird das Prinzip der Komplementärfarbe (blau emittierende Lichtquelle und gelb emittierender Leuchtstoff) zur Erzielung einer weißen Lichtfarbe verwendet.

Schließlich ist in EP-A 124 175 eine Leuchtstofflampe beschrieben, die neben einer Quecksilberfüllung mehrere Leuchtstoffe enthält. Diese werden durch die UV-Strahlung (254 nm) oder auch durch die kurzwellige Strahlung bei 460 nm angeregt. Drei Leuchtstoffe sind so gewählt, daß sie sich zu weiß addieren (Farbmischung).

### Darstellung der Erfindung

Es ist Aufgabe der vorliegenden Erfindung, einen Leuchtstoff gemäß dem Oberbegriff des Anspruchs 1 bereitzustellen, der beständig gegen hohe thermische Belastung ist und sich gut für die Anregung im kurzwelligen sichtbaren Spektralbereich eignet.

Diese Aufgabe wird durch die kennzeichnenden Merkmale des Anspruchs 1 gelöst. Besonders vorteilhafte Ausgestaltungen finden sich in den abhängigen Ansprüchen.

Erfindungsgemäß wird ein Leuchtstoff für Lichtquellen, deren Emission im kurzwelligen optischen Spektralbereich liegt, verwendet, der eine Granatstruktur $A_3B_5O_{12}$ besitzt und der mit Ce dotiert ist, wobei die zweite Komponente B mindestens eines der Elemente Al und Ga repräsentiert, wobei die erste Komponente A Terbium enthält. Überraschenderweise hat sich herausgestellt, daß sich Terbium (Tb) unter besonderen Umständen, nämlich bei blauer Anregung im Bereich 420 bis 490 nm, als Bestandteil des Wirtsgitters (erste Komponente des Granats) für einen gelb emittierenden Leuchtstoff eignet, dessen Aktivator Cer ist. Bisher wurde Tb in diesem Zusammenhang lediglich als Aktivator oder Koaktivator neben Cer für die Emission im Grünen in Betracht gezogen, wenn die Anregung durch Kathodenstrahlen (Elektronen) oder kurzwellige UV-Photonen erfolgt (GB-A 1 600 492 und EP-A 208 713).

Dabei kann Terbium als Hauptbestandteil der ersten Komponente A des Granats in Alleinstellung oder zusammen mit mindestens einer der Seltenerdmetalle Y, Gd, La u/o Lu verwendet werden.

Als zweite Komponente wird mindestens eines der Elemente Al oder Ga verwendet. Die zweite Komponente B kann zusätzlich In enthalten. Der Aktivator ist Cer.

In einer besonders bevorzugten Ausführungsform wird ein Granat der Struktur

$$(Tb_{1-x-y}SE_xCe_y)_3(Al,Ga)_5O_{12} \text{ verwendet,}$$

wobei

$$SE = Y, Gd, La \text{ und/oder } Lu;$$

$$0 \leq x \leq 0{,}5\text{-}y;$$

$$0 < y < 0{,}1 \text{ gilt.}$$

Der Leuchtstoff absorbiert im Bereich 420 bis 490 nm und kann so durch die Strahlung einer blauen Lichtquelle, die insbesondere die Strahlungsquelle für eine Lampe oder LED ist, angeregt werden. Gute Ergebnisse wurden mit einer blauen LED erzielt, deren Emissionsmaximum bei 430 bis 470 nm lag. Das Maximum der Emission des Tb-Granat:Ce-Leuchtstoffs liegt bei etwa 550 nm.

Dieser Leuchtstoff eignet sich besonders für die Verwendung in einer weißen LED, beruhend auf der Kombination einer blauen LED mit dem Tb-Granat-haltigen Leuchtstoff, der durch Absorption eines Teils der Emission der blauen LED angeregt wird und dessen Emission die übrig bleibende Strahlung der LED zu weißem Licht ergänzt.

Als blaue LED eignet sich insbesondere eine Ga(In)N-LED, aber auch jeder andere Weg zur Erzeugung einer blauen LED mit einer Emission im Bereich 420 bis 490 nm. Insbesondere wird als hauptsächlicher Emissionsbereich 430 bis 470 nm empfohlen, da dann die Effizienz am höchsten ist.

Durch die Wahl von Art und Menge an Seltenerdmetallen ist eine Feineinstellung der Lage der Absorptions- und der Emissionsbande möglich, ähnlich wie dies für andere Leuchtstoffe des Typs YAG:Ce aus der Literatur bekannt ist. In Verbindung mit Leuchtdioden eignet sich vor allem ein Bereich für x, der zwischen $0,25 \leq x \leq 0,5-y$ liegt.

Der besonders bevorzugte Bereich von y liegt bei $0,02 < y < 0,06$.

Der erfindungsgemäße Leuchtstoff eignet sich auch zur Kombination mit anderen Leuchtstoffen.

Gute Eignung als Leuchtstoff zeigt ein Granat der Struktur

$$(Tb_xSE_{1-x-y}Ce_y)_3(Al,Ga)_5O_{12},$$

wobei

$$SE = Y, Gd, La \text{ und/oder } Lu;$$

$$0 \leq x \leq 0,02, \text{ insbesondere } x = 0,01;$$

$0 < y < 0,1$ gilt. Häufig liegt y im Bereich 0,01 bis 0,05.

Generell dienen kleinere Mengen an Tb im Wirtsgitter vor allem dazu, die Eigenschaften bekannter Cer-aktivierter Leuchtstoffe zu verbessern, während die Zugabe größerer Mengen an Tb gezielt vor allem dafür eingesetzt werden kann, die Wellenlänge der Emission bekannter Cer-aktivierter Leuchtstoffe zu verschieben. Daher eignet sich ein hoher Anteil Tb besonders gut für weiße LED mit niedriger Farbtemperatur unter 5000 K.

**Figuren**

Im folgenden soll die Erfindung anhand mehrerer Ausführungsbeispiele näher erläutert werden. Es zeigen:

Figur 1     ein Emissionsspektrum eines ersten Tb-Granat-Leuchtstoffs;

Figur 2     das Remissionsspektrum dieses Tb-Granat-Leuchtstoffs;

Figur 3     Emissionsspektren weiterer Tb-Granat-Leuchtstoffe;

Figur 4     Remissionsspektren der Tb-Granat-Leuchtstoffe aus Figur 3;

Figur 5     Emissionsspektren weiterer Tb-Granat-Leuchtstoffe;

Figur 6     Remissionsspektren der Tb-Granat-Leuchtstoffe aus Figur 5;

Figur 7     ein Emissionsspektrum einer weißen LED mit Tb-Granat-Leuchtstoff.

**Beschreibung mehrerer Ausführungsbeispiele**

Ausführungsbeispiel Nr. 1:

Die Komponenten

| | |
|---|---|
| 9,82 g | Yttriumoxid $Y_2O_3$ |
| 2,07 g | Ceroxid $CeO_2$ |
| 37,57 g | Terbiumoxid $Tb_4O_7$ |
| 26,41 g | Aluminiumoxid $Al_2O_3$ |
| 0,15 g | Bariumfluorid $BaF_2$ |
| 0,077 g | Borsäure $H_3BO_3$ |

werden vermischt und in einer 250-ml-Polyethylen-Weithalsflasche mit 150 g Aluminiumoxidkugeln von 10 mm Durchmesser zwei Stunden lang zusammen vermahlen.

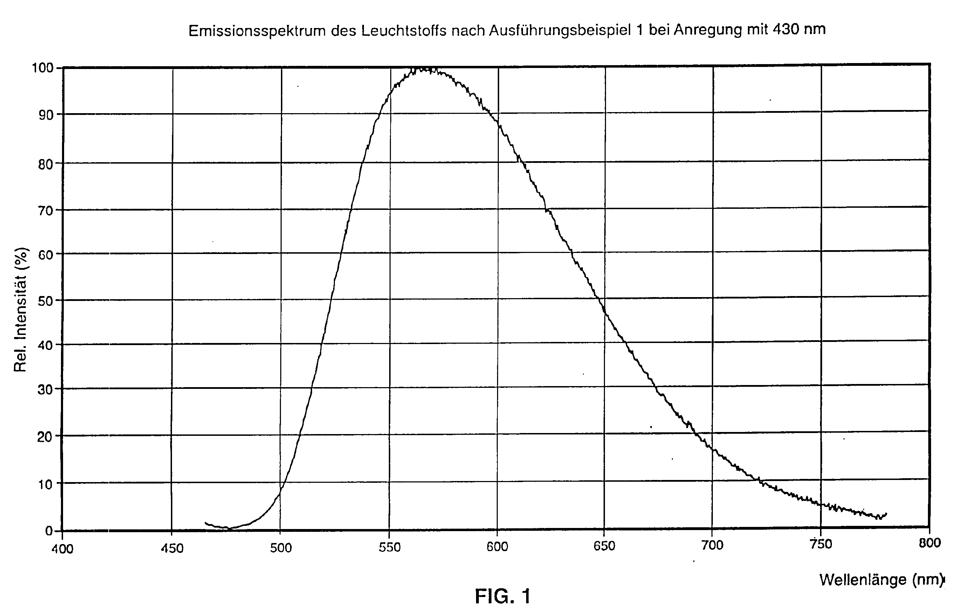

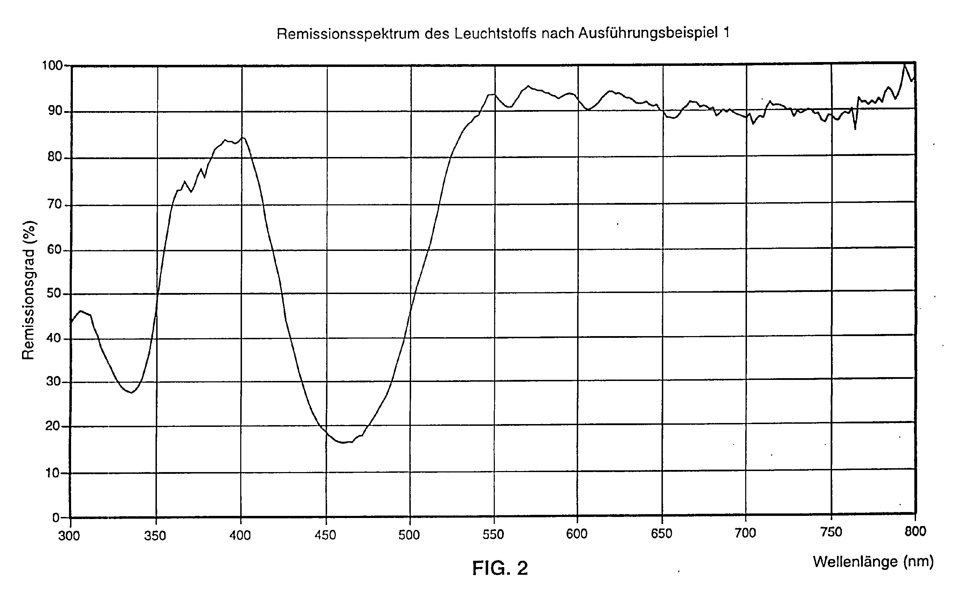

Dabei dienen Bariumfluorid und Borsäure als Flußmittel. Die Mischung wird in einem bedeckten Korundtiegel für drei Std. bei 1550 °C in Formiergas (Stickstoff mit 2,3 Vol-% Wasserstoff) geglüht. Das Glühgut wird in einer automatischen Mörsermühle gemahlen und durch ein Sieb von 53 μm Maschenweite gesiebt. Anschließend erfolgt eine zweite Glühung für drei Std. bei 1500 °C in Formiergas (Stickstoff mit 0,5 Vol-% Wasserstoff). Danach wird wie nach der ersten Glühung gemahlen und gesiebt. Der erhaltene Leuchtstoff entspricht der Zusammensetzung $(Y_{0,29}Tb_{0,67}Ce_{0,04})_3Al_5O_{12}$. Er weist eine kräftig gelbe Körperfarbe auf. Ein Emissionsspektrum dieses Leuchtstoffs bei Anregung mit 430 nm und ein Remissionsspektrum des Leuchtstoffs zwischen 300 und 800 nm sind in Figur 1 und 2 wiedergegeben.

Ausführungsbeispiel Nr. 2:

Die Komponenten

| | |
|---|---|
| 43,07 g | Terbiumoxid $Tb_4O_7$ |
| 1,65 g | Ceroxid $CeO_2$ |
| 21,13 g | Aluminiumoxid $Al_2O_3$ |
| 0,12 g | Bariumfluorid $BaF_2$ |
| 0,062 g | Borsäure $H_3BO_3$ |

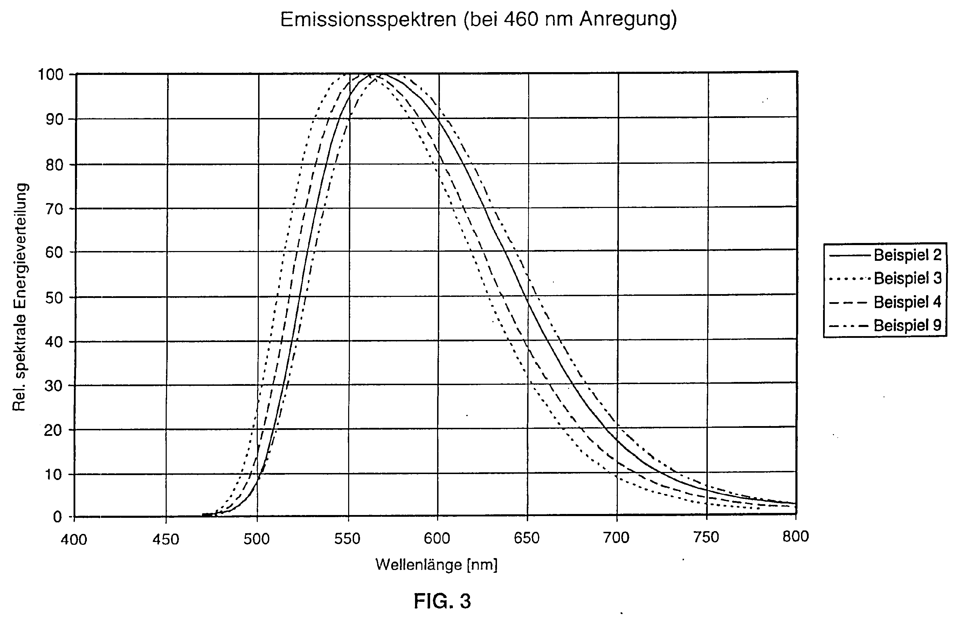

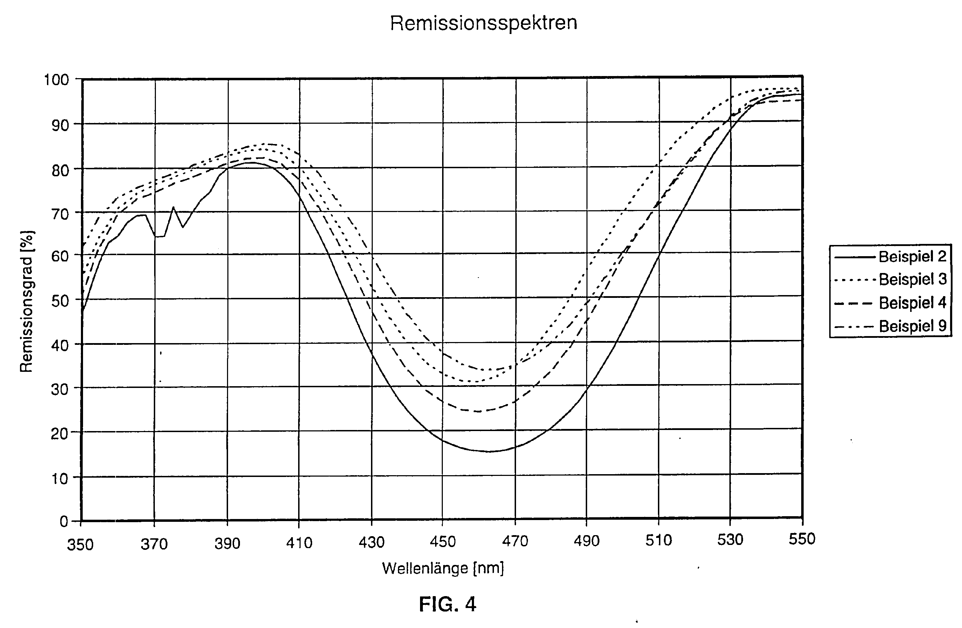

werden wie unter Beispiel Nr. 1 beschrieben innig gemischt. Zwei Glühungen und die weitere Aufarbeitung der Glühprodukte erfolgen wie unter Beispiel 1 beschrieben. Der erhaltene Leuchtstoff entspricht der gesamten Zusammensetzung $(Tb_{0.96}Ce_{0.04})_3Al_5O_{12}$ oder in der das Wirtsgitter verdeutlichenden Darstellung $Tb_3Al_5O_{12}$:Ce. Er weist eine kräftig gelbe Körperfarbe auf. Das Röntgenbeugungsdiagramm zeigt, dass eine kubische Granatphase vorliegt. Das Emissionsspektrum und Remissionsspektrum dieses Leuchtstoffs ist in Figur 3 bzw. 4 gezeigt.

Ausführungsbeispiel Nr. 3:

Die Komponenten

| | |
|---|---|
| 32,18 g | Yttriumoxid $Y_2O_3$ |
| 0,56 g | Terbiumoxid $Tb_4O_7$ |
| 2,07 g | Ceroxid $CeO_2$ |
| 26,41 g | Aluminiumoxid $Al_2O_3$ |
| 0,077 g | Borsäure $H_3BO_3$ |

werden wie unter Beispiel Nr. 1 beschrieben innig gemischt. Zwei Glühungen und Aufarbeitung der Glühprodukte erfolgen wie unter Beispiel Nr. 1 beschrieben. Der erhaltene Leuchtstoff entspricht der Zusammensetzung $(Y_{0.95}Tb_{0.01}Ce_{0.04})_3Al_5O_{12}$. Er weist eine kräftig gelbe Körperfarbe auf. Das Emissionsspektrum und Remissionsspektrum dieses Leuchtstoffs ist in Figur 3 bzw. 4 gezeigt.

Ausführungsbeispiel Nr. 4:

Die Komponenten

| | |
|---|---|
| 26,76 g | Yttriumoxid $Y_2O_3$ |
| 9,53 g | Terbiumoxid $Tb_4O_7$ |
| 2,07 g | Ceroxid $CeO_2$ |
| 26,41 g | Aluminiumoxid $Al_2O_3$ |
| 0,149 g | Bariumfluorid $BaF_2$ |
| 0,077 g | Borsäure $H_3BO_3$ |

werden wie unter Beispiel Nr. 1 beschrieben innig gemischt. Zwei Glühungen und Aufarbeitung der Glühprodukte erfolgen wie unter Beispiel Nr. 1 beschrieben. Der erhaltene Leuchtstoff entspricht der Zusammensetzung $(Y_{0.79}Tb_{0.17}Ce_{0.04})_3Al_5O_{12}$. Er weist eine kräftig gelbe Körperfarbe auf. Das Emissionsspektrum und Remissionsspektrum dieses Leuchtstoffs ist in Figur 3 bzw. 4 gezeigt.

Ausführungsbeispiel Nr. 5

Die Komponenten

| | |
|---|---|
| 30,82 g | Yttriumoxid $Y_2O_3$ |
| 0.56 g | Terbiumoxid $Tb_4O_7$ |
| 4,13 g | Ceroxid $CeO_2$ |
| 26,41 g | Aluminiumoxid $Al_2O_3$ |
| 0,149 g | Bariumfluorid $BaF_2$ |
| 0,077 g | Borsäure $H_3BO_3$ |

werden wie unter Beispiel Nr. 1 beschrieben innig gemischt. Zwei Glühungen und Aufarbeitung der Glühprodukte erfolgen wie unter Beispiel Nr. 1 beschrieben. Der erhaltene Leuchtstoff entspricht der Zusammensetzung $(Y_{0.91}Tb_{0.01}Ce_{0.08})_3Al_5O_{12}$. Er weist eine kräftig gelbe Körperfarbe auf.

Ausführungsbeispiel Nr. 6:

Die Komponenten

| | |
|---|---|
| 43,07 g | Terbiumoxid $Tb_4O_7$ |
| 1,65 g | Ceroxid $CeO_2$ |
| 21,13 g | Aluminiumoxid $Al_2O_3$ |
| 0,062 g | Borsäure $H_3BO_3$ |

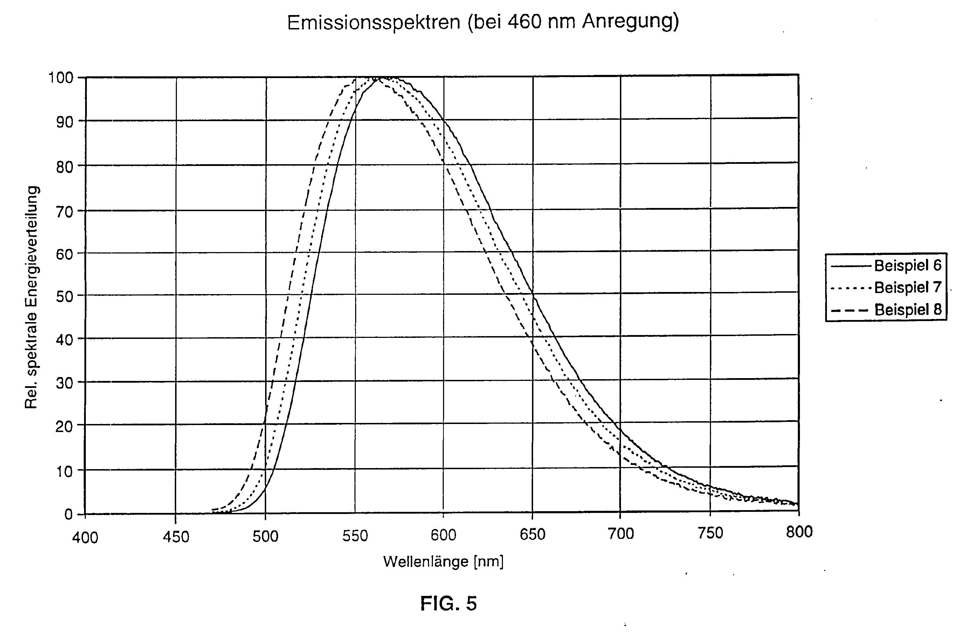

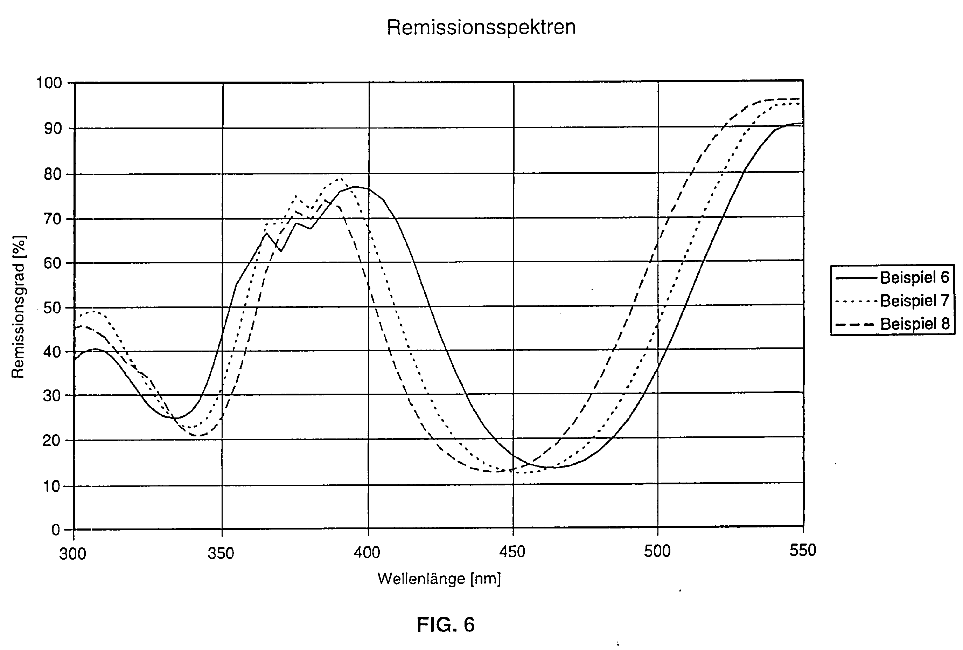

werden wie unter Beispiel Nr. 1 beschrieben innig gemischt. Zwei Glühungen und Aufarbeitung der Glühprodukte erfolgen wie unter Beispiel 1 beschrieben, jedoch ist die Glühtemperatur bei den beiden Glühungen jeweils 50 °C niedriger. Der erhaltene Leuchtstoff entspricht der Zusammensetzung $(Tb_{0.96}Ce_{0.04})_3Al_5O_{12}$. Er weist eine kräftig gelbe Körperfarbe auf. Das Emissionsspektrum und Remissionsspektrum dieses Leuchtstoffs ist in Figur 5 bzw. 6 gezeigt.

Ausführungsbeispiel Nr. 7:

Die Komponenten

| | |
|---|---|
| 43,07 g | Terbiumoxid $Tb_4O_7$ |
| 1,65 g | Ceroxid $CeO_2$ |
| 17,05 g | Aluminiumoxid $Al_2O_3$ |
| 7,50 g | Galliumoxid $Ga_2O_3$ |
| 0,062 g | Borsäure $H_3BO_3$ |

werden wie unter Beispiel Nr. 1 beschrieben innig gemischt. Zwei Glühungen und Aufarbeitung der Glühprodukte erfolgen wie unter Beispiel 1 beschrieben, jedoch ist die Glühtemperatur bei beiden Glühungen jeweils 50 °C niedriger. Der erhaltene Leuchtstoff entspricht der Zusammensetzung $(Tb_{0.96}Ce_{0.04})_3Al_4GaO_{12}$. Er weist eine kräftig gelbe Körperfarbe auf. Das Emissionsspektrum und Remissionsspektrum dieses Leuchtstoffs ist in Figur 5 bzw. 6 gezeigt.

Ausführungsbeispiel Nr. 8:

Die Komponenten

| | |
|---|---|
| 43,07 g | Terbiumoxid $Tb_4O_7$ |
| 1,65 g | Ceroxid $CeO_2$ |
| 12,97 g | Aluminiumoxid $Al_2O_3$ |
| 15,00 g | Galliumoxid $Ga_2O_3$ |
| 0,062 g | Borsäure $H_3BO_3$ |

werden wie unter Beispiel Nr. 1 beschrieben innig gemischt. Zwei Glühungen und Aufarbeitung der Glühprodukte erfolgen wie unter Beispiel 1 beschrieben, jedoch ist die Glühtemperatur bei beiden Glühungen jeweils 50 °C niedriger. Der erhaltene Leuchtstoff entspricht der Zusammensetzung $(Tb_{0,96}Ce_{0,04})_3Al_3Ga_2O_{12}$. Er weist eine gelbe Körperfarbe auf. Das Emissionsspektrum und Remissionsspektrum dieses Leuchtstoffs ist in Figur 5 bzw. 6 gezeigt.

Ausführungsbeispiel Nr. 9

Die Komponenten

| | |
|---|---|
| 4,88 kg | Yttriumoxid $Y_2O_3$ |
| 7,05 kg | Gadoliniumoxid $Gd_2O_3$ |
| 161,6 g | Terbiumoxid $Tb_4O_7$ |
| 595 g | Ceroxid $CeO_2$ |
| 7,34 kg | Aluminiumoxid $Al_2O_3$ |
| 5,50 g | Borsäure $H_3BO_3$ |

werden in einem 60 l Polyethylenfass 24 Stunden gemischt. Die Mischung wird in Glühtiegel aus Aluminiumoxid von ca. 1 l Fassungsvermögen eingefüllt und in einem Durchschubofen 6 Stunden bei 1550 °C in Formiergas geglüht. Das geglühte Material wird in einer automatischen Mörsermühle gemahlen und anschließend fein gesiebt. Der erhaltene Leuchtstoff hat die Zusammensetzung $(Y_{0,50}Gd_{0,45}Tb_{0,01}Ce_{0,04})_3Al_5O_{12}$. Er weist eine kräftig gelbe Körperfarbe auf. Das Emissionsspektrum und Remissionsspektrum dieses Leuchtstoffs ist in Figur 3 bzw. 4 gezeigt.

Ausführungsbeispiel 10 (LED):

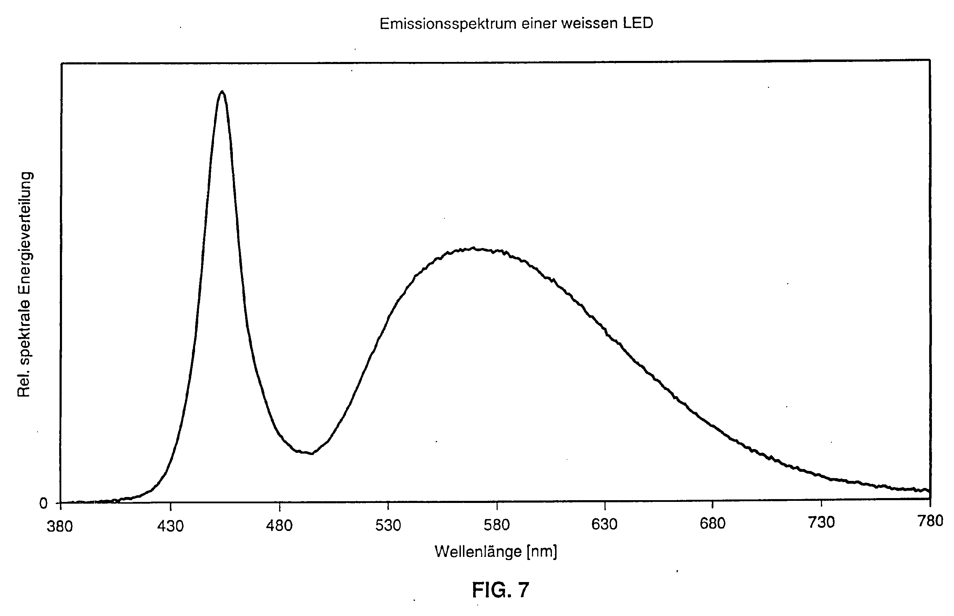

Beim Einsatz dieser Leuchtstoffe in einer weißen LED zusammen mit GaInN wird ein Aufbau ähnlich wie in WO 97/50132 beschrieben verwendet. Beispielsweise werden gleiche Teile von Leuchtstoff nach Beispiel 1 und von Leuchtstoff nach Beispiel 4 in Epoxidharz dispergiert und mit dieser Harzmischung eine LED mit einem Emissionsmaximum von etwa 450 nm (blau) umhüllt. Das Emissionsspektrum einer so erhaltenen weißen LED ist in Figur 7 dargestellt. Die Mischung der blauen LED-Strahlung mit der gelben Leuchtstoff-Emission ergibt in diesem Fall einen Farbort von x = 0,359 / y = 0,350, entsprechend weißem Licht der Farbtemperatur 4500 K.

Die oben beschriebenen Leuchtstoffe weisen im allgemeinen gelbe Körperfarbe auf. Sie emittieren im gelben Spektralbereich. Bei Zugabe oder alleiniger Verwendung von Ga statt Al verschiebt sich die Emission mehr in Richtung grün, so dass sich insbesondere auch höhere Farbtemperaturen realisieren lassen. Insbesondere können Ga-haltige (oder Ga,Al-haltige) Tb-Granate und rein Al-haltige Tb-Granate gemischt verwendet werden um eine Anpassung an gewünschte Farbörter vornehmen zu können.

**Patentansprüche**

1.  Leuchtstoff mit einer Granatstruktur $A_3B_5O_{12}$. wobei der Leuchtstoff mit Ce aktiviert ist entsprechend der Darstellung $A_3B_5O_{12}$:Ce, wobei die zweite Komponente B mindestens eines der Elemente Al und Ga repräsentiert, **dadurch gekennzeichnet, daß** die erste Komponente A Terbium enthält, und zwar in einer Mindestmenge von 1 mol-%.

2.  Leuchtstoff nach Anspruch 1, **dadurch gekennzeichnet, daß** die erste Komponente A überwiegend oder allein durch Terbium gebildet ist.

3.  Leuchtstoff nach Anspruch 1, **dadurch gekennzeichnet, daß** der Leuchtstoff durch eine Strahlung im Bereich 430 bis 470 nm, anregbar ist.

4.  Leuchtstoff nach Anspruch 1, **dadurch gekennzeichnet, daß** die erste Komponente neben Tb Anteile von Y, Gd, La u/o Lu verwendet.

5.  Leuchtstoff nach Anspruch 1, **dadurch gekennzeichnet, daß** ein Granat der Struktur

$$(Tb_{1-x-y}SE_xCe_y)_3(Al,Ga)_5O_{12} \text{ verwendet,}$$

wobei

$$SE = Y, Gd, La \text{ und/oder } Lu;$$

$$0 \leq x \leq 0,5\text{-}y;$$

$$0 < y < 0,1 \text{ gilt.}$$

6.  Leuchtstoff nach Anspruch 1, **dadurch gekennzeichnet, daß** die zweite Komponente B zusätzlich In enthält.

7.  Verwendung eines Leuchtstoffs gemäß einem der vorhergehenden Ansprüche zur Anregung durch eine im Blauen zwischen 420 und 490 nm emittierenden Lichtquelle.

8.  Lichtquelle, die primär Strahlung im kurzwelligen Bereich des optischen Spektralbereichs zwischen 420 und 490 nm emittiert, wobei diese Strahlung teilweise oder vollständig mittels eines Leuchtstoffs nach einem der vorhergehenden Ansprüche 1 bis 6 in längerwellige Strahlung konvertiert wird.

9.  Lichtquelle nach Anspruch 8, **dadurch gekennzeichnet, daß** die primär emittierte Strahlung im Wellenlängenbereich 430 bis 470 nm liegt.

**10.** Lichtquelle nach Anspruch 8, **dadurch gekennzeichnet, daß** als primäre Strahlungsquelle eine blau emittierende Leuchtdiode, insbesondere auf Basis von Ga(In)N, verwendet wird.

**11.** Verfahren zur Herstellung eines Leuchtstoffs gemäß einem der Ansprüche 1 bis 6, **gekennzeichnet durch** folgende Verfahrensschritte:

     a. Vermahlen der Oxide und Zugabe eines Flußmittels;

     b. Erstes Glühen in Formiergas;

     c. Mahlen und Sieben;

     d. Zweites Glühen.

Emissionsspektrum des Leuchtstoffs nach Ausführungsbeispiel 1 bei Anregung mit 430 nm

FIG. 1

Remissionsspektrum des Leuchtstoffs nach Ausführungsbeispiel 1

FIG. 2

Emissionsspektren (bei 460 nm Anregung)

FIG. 3

EP 1 378 556 A2

FIG. 4

Emissionsspektren (bei 460 nm Anregung)

FIG. 5

EP 1 378 556 A2

# Remissionsspektren

FIG. 6

Emissionsspektrum einer weissen LED

Wellenlänge [nm]

FIG. 7

EP 1 378 556 A2